# EUROPEAN PATENT APPLICATION

(11) **EP 4 435 833 A1**
(43) Date of publication of application: **25.09.2024**
(21) Application number: 22895305.5
(22) Date of filing: 17.10.2022
(51) Int. Cl.: H01L 21/20, H01L 21/02, H01L 27/12

(54) **NITRIDE SEMICONDUCTOR SUBSTRATE, AND METHOD FOR PRODUCING NITRIDE SEMICONDUCTOR SUBSTRATE**

(30) Priority: 17.11.2021 JP 2021186815
(71) Applicant: Shin-Etsu Handotai Co., Ltd., Tokyo 100-0004 (JP)
(72) Inventor: HAGIMOTO Kazunori, Annaka-shi, Gunma 379-0196 (JP); KUBONO Ippei, Annaka-shi, Gunma 379-0196 (JP)
(74) Representative: Mooser, Sebastian Thomas
(86) International application number: PCT/JP2022/038552
(87) International publication number: WO 2023/090019

(57) **Abstract**

The present invention is a nitride semiconductor substrate for high frequency, which includes an SOI substrate in which a single crystal silicon thin film is formed on a single crystal silicon substrate via a silicon oxide layer, and a nitride semiconductor layer including a GaN layer formed on the SOI substrate; in which the single crystal silicon thin film contains nitrogen at a concentration of 2.0 × 10¹⁴ atoms/cm³ or more and has a resistivity of 100 Qcm or more, the single crystal silicon substrate has a resistivity of 50 mΩcm or less, and the silicon oxide layer has a thickness of 10 to 400 nm. This can provide the nitride semiconductor substrate in which the nitride semiconductor layer is grown on the SOI substrate for manufacturing devices for high frequency, and the nitride semiconductor substrate with suppressed plastic deformation.

## Description

### TECHNICAL FIELD

The present invention relates to a nitride semiconductor substrate and a method for manufacturing the nitride semiconductor substrate.

### BACKGROUND ART

A MOCVD method, which is one of methods for manufacturing a semiconductor thin film, is widely used because the method has excellent diameter enlargement ability and mass productivity and can form a uniform thin film crystal. Nitride semiconductors typified by GaN are promising as a next-generation semiconductor material beyond the limit of Si as a material. As a substrate for epitaxially growing GaN, etc. in the MOCVD method, GaN, SiC, sapphire, Si, etc. are used.

In recent years, a substrate in which a single crystal silicon substrate is laminated onto an insulation layer (such as SiO₂), represented by SOI, is practically applied as a substrate for epitaxially growing GaN. For example, Patent Documents 1 to 4 disclose growth of the nitride semiconductor on an SOI substrate. In GaN/SOI, each discrete part can be electrically separated from each other, and this insulation method is proven to eliminate a back-gate effect (which is a variation of a threshold voltage of a MOSFET due to a voltage of the substrate) and reduce switching noise. Such characteristics are merits which are not exhibited with the silicon substrate, the GaN substrate, etc. SOI substrate can be obtained by bonding between substrates, for example, as disclosed in Patent Documents 5 and 6.

Incidentally, manufacture of devices for high frequency has been recently performed by epitaxially growing the nitride semiconductors on silicon single crystal seed layers, as disclosed in Patent Document 7.

In the devices for high frequency, characteristics degradation due to substrates, losses and degradation of second and third-harmonic characteristics due to the substrates have been observed.

For substrates for the high frequency device, GaN layers is epitaxially grown by using high resistivity substrates in general to manufacture devices for high frequency.

The substrate for the high frequency device uses a high resistivity substrate to prevent signal flow from an epitaxial layer to an underlying Si substrate. In addition, when a nitride semiconductor epitaxial layer is stacked on a high resistivity silicon substrate, the nitride semiconductor epitaxial layer is stacked by devising a buffer layer as a stress-relaxing layer. However, the high resistivity silicon substrate is plastically deformed due to stress during epitaxial growth. In order to solve this problem, it is preferred to use the SOI substrate made of the high resistivity silicon substrate which is bonded to a stress-resistant low-resistivity substrate (a hard single crystal silicon substrate dedicated for nitride semiconductor epitaxial growth) via a silicon oxide layer.

However, even a nitride semiconductor substrate for manufacturing the device for high frequency manufactured in this way may be plastically deformed during the epitaxial growth of the nitride semiconductor.

### CITATION LIST

### PATENT LITERATURE

Patent Document 1: JP 2010-40737 A
Patent Document 2: JP 2011-97062 A
Patent Document 3: JP 2019-208022 A
Patent Document 4: JP 5396369 B
Patent Document 5: JP 5233111 B
Patent Document 6: JP 2010-278339 A
Patent Document 7: JP 2021-100087 A

### SUMMARY OF INVENTION

### TECHNICAL PROBLEM

The present invention has been made to solve the above-described problem. An object of the present invention is to provide a nitride semiconductor substrate in which a nitride semiconductor layer is grown on an SOI substrate for manufacturing a device for high frequency and a method for manufacturing the same, the nitride semiconductor substrate with suppressed plastic deformation.

### SOLUTION TO PROBLEM

To solve the above-described problem, the present invention provides a nitride semiconductor substrate for high frequency comprising:
an SOI substrate in which a single crystal silicon thin film is formed on a single crystal silicon substrate via a silicon oxide layer; and
a nitride semiconductor layer including a GaN layer formed on the SOI substrate,
wherein the single crystal silicon thin film contains nitrogen at a concentration of 2.0 × 10¹⁴ atoms/cm³ or more and has a resistivity of 100 Qcm or more,
the single crystal silicon substrate has a resistivity of 50 mΩcm or less, and
the silicon oxide layer has a thickness of 10 to 400 nm.

The nitride semiconductor substrate with the nitride semiconductor layer including the GaN layer is formed on the SOI substrate in which the single crystal silicon thin film contains nitrogen at a concentration of 2.0 × 10¹⁴ atoms/cm³ or more; the single crystal silicon thin film has a resistivity of 100 Qcm or more; the single crystal silicon substrate has a resistivity of 50 mΩcm or less; and the silicon oxide layer has a thickness of 10 to 400 nm, as described above, can be the nitride semiconductor substrate having suppressed plastic deformation. In addition, by using this nitride semiconductor substrate, a device for high frequency having excellent high frequency characteristics can be manufactured.

The silicon oxide layer preferably has a thickness of 10 to 200 nm.

When the silicon oxide layer has a thickness of 10 to 200 nm, the nitride semiconductor substrate can be made with further suppressed plastic deformation.

In addition, the present invention provides a method for manufacturing a nitride semiconductor substrate for high frequency, the method comprising the steps of:
providing two single crystal silicon substrates serving as a bond wafer and a base wafer;
bonding the two single crystal silicon substrates to each other via a silicon oxide layer;
thinning the bond wafer into a single crystal silicon thin film to obtain an SOI substrate, in which the single crystal silicon thin film is formed via the silicon oxide layer on the base wafer; and
growing a nitride semiconductor layer including a GaN layer on the single crystal silicon thin film of the SOI substrate to obtain a nitride semiconductor substrate having the nitride semiconductor layer formed on the SOI layer,
wherein a substrate containing nitrogen at a concentration of 2.0 × 10¹⁴ atoms/cm³ or more and having a resistivity of 100 Qcm or more is used as the single crystal silicon substrate serving as the bond wafer,
a substrate having a resistivity of 50 mΩcm or less is used as the single crystal silicon substrate serving as the base wafer, and
a layer having a thickness of 10 to 400 nm is used as the silicon oxide layer.

By virtue of such a method for manufacturing a nitride semiconductor, the nitride semiconductor substrate in which plastic deformation is relatively easily and reliably suppressed can be manufactured. Moreover, by using the nitride semiconductor substrate manufactured in this way, the device for high frequency having excellent high frequency characteristics can be manufactured.

It is preferred that the layer having a thickness of 10 to 200 nm is used as the silicon oxide layer.

When the layer having a thickness of 10 to 200 nm is used as the silicon oxide layer, the nitride semiconductor substrate with further suppressed plastic deformation can be manufactured.

The single crystal silicon substrate serving as the bond wafer can be manufactured by an FZ method or an MCZ method and then provided.

The single crystal silicon substrate serving as the bond wafer can be manufactured by, for example, the FZ method or the MCZ method.

### ADVANTAGEOUS EFFECTS OF INVENTION

As described above, the inventive nitride semiconductor substrate can be the nitride semiconductor substrate with suppressed plastic deformation. Moreover, by using the inventive nitride semiconductor substrate, the device for high frequency having excellent high frequency characteristics can be manufactured.

Furthermore, by virtue of the inventive method for manufacturing the nitride semiconductor substrate, the nitride semiconductor substrate for high frequency in which plastic deformation is suppressed can be relatively easily and reliably manufactured. Moreover, when the nitride semiconductor substrate manufactured by the inventive method for manufacturing the nitride semiconductor is used, the device for high frequency having excellent high frequency characteristics can be manufactured.

### BRIEF DESCRIPTION OF DRAWINGS

FIG. 1 is a schematic cross-sectional view illustrating an example of a nitride semiconductor substrate according to the present invention.
FIG. 2 is a schematic view of a configuration of an example of a nitride semiconductor substrate according to the present invention.
FIG. 3 is a graph illustrating the change of warp state during epitaxial growth in Examples and Comparative Examples.
FIG. 4 is a graph illustrating relations between thicknesses and warps of the silicon oxide layers in Examples and Comparative Examples.

### DESCRIPTION OF EMBODIMENTS

As described above, when a nitride semiconductor is epitaxially grown on an SOI substrate having a single crystal silicon thin film with a high resistivity to manufacture a device for high frequency, plastic deformation may have occurred during epitaxial growth.

The present inventors have earnestly studied the nitride semiconductor substrate with suppressed plastic deformation and a manufacturing method thereof and found out that the nitride semiconductor substrate with suppressed plastic deformation can be manufactured by having the single crystal silicon thin film of the SOI substrate containing nitrogen at a concentration of 2.0 × 10¹⁴ atoms/cm³ or more, the single crystal silicon thin film having a resistivity of 100 Qcm or more, the single crystal silicon substrate having a resistivity of 50 mΩcm or less, and the silicon oxide layer of the SOI substrate having a thickness of 10 to 400 nm. This finding led to the completion of the present invention.

In other words, the present invention is a nitride semiconductor substrate for high frequency comprising:
an SOI substrate in which a single crystal silicon thin film is formed on a single crystal silicon substrate via a silicon oxide layer; and
a nitride semiconductor layer including a GaN layer formed on the SOI substrate,
wherein the single crystal silicon thin film contains nitrogen at a concentration of 2.0 × 10¹⁴ atoms/cm³ or more and has a resistivity of 100 Qcm or more,
the single crystal silicon substrate has a resistivity of 50 mΩcm or less, and
the silicon oxide layer has a thickness of 10 to 400 nm.

In addition, the present invention is a method for manufacturing a nitride semiconductor substrate for high frequency, the method comprising the steps of:
providing two single crystal silicon substrates serving as a bond wafer and a base wafer;
bonding the two single crystal silicon substrates to each other via a silicon oxide layer;
thinning the bond wafer into a single crystal silicon thin film to obtain an SOI substrate, in which the single crystal silicon thin film is formed via the silicon oxide layer on the base wafer; and
growing a nitride semiconductor layer including a GaN layer on the single crystal silicon thin film of the SOI substrate to obtain a nitride semiconductor substrate having the nitride semiconductor layer formed on the SOI layer,
wherein a substrate containing nitrogen at a concentration of 2.0 × 10¹⁴ atoms/cm³ or more and having a resistivity of 100 Qcm or more is used as the single crystal silicon substrate serving as the bond wafer,
a substrate having a resistivity of 50 mΩcm or less is used as the single crystal silicon substrate serving as the base wafer, and
a layer having a thickness of 10 to 400 nm is used as the silicon oxide layer.

Hereinafter, the present invention will be described in detail with reference to the drawings. However, the present invention is not limited thereto.

### [Nitride Semiconductor Substrate]

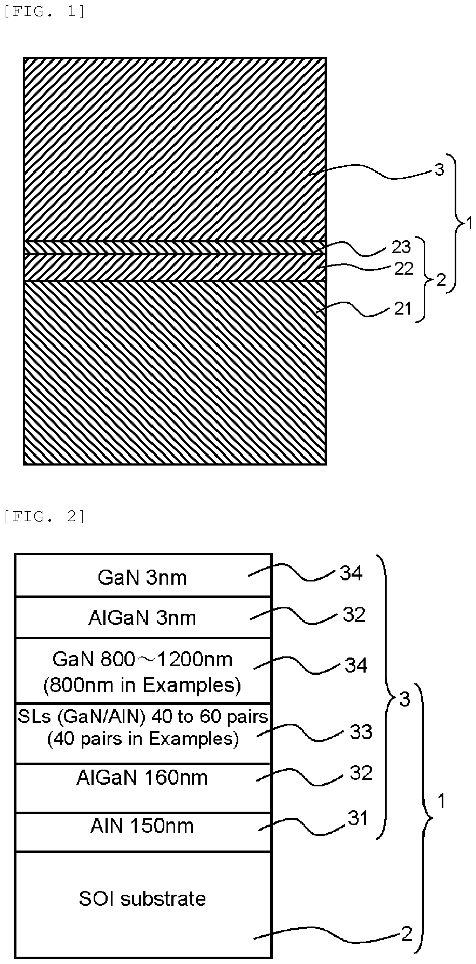

FIG. 1 shows a schematic cross-sectional view of an example of a nitride semiconductor substrate according to the present invention. FIG. 2 shows a schematic view of a configuration of an example of the nitride semiconductor substrate according to the present invention.

A nitride semiconductor substrate 1 shown in FIG. 1 includes an SOI substrate 2 and a nitride semiconductor layer (nitride semiconductor thin film) 3.

In the SOI substrate 2, a single crystal silicon thin film 23 is formed on a single crystal silicon substrate 21 via a silicon oxide layer 22.

The nitride semiconductor layer 3 includes a GaN layer 34 shown in FIG. 2. The nitride semiconductor layer 3 shown in FIG. 2 includes an AlN layer 31, an AlGaN layer 32, and superlattice layers (SLs) 33 in addition to the GaN layer 34; however, the nitride semiconductor layer 3 is not limited to a configuration like the one shown in FIG. 2 as long as the GaN layer 34 is included.

The single crystal silicon thin film 23 of the SOI substrate 2 of the nitride semiconductor substrate 1 contains nitrogen at a concentration of 2.0 × 10¹⁴ atoms/cm³ or more and has a resistivity of 100 Qcm or more. Moreover, the single crystal silicon substrate 21 has a resistivity of 50 mΩcm or less. Furthermore, the silicon oxide layer 22 has a thickness of 10 to 400 nm.

Such an SOI substrate 2 can exhibit high strength even when the SOI substrate 2 has the SOI layer 23 with a high resistivity. The inventive nitride semiconductor substrate 1 can be the substrate with suppressed plastic deformation by virtue of including such an SOI substrate 2.

On the other hand, when the nitrogen concentration in the single crystal silicon thin film 23 is less than 2.0 × 10¹⁴ atoms/cm³, plastic deformation cannot be sufficiently suppressed. The upper limit of the nitrogen concentration in the single crystal silicon thin film 23 is not particularly limited but can be 1.0 × 10²⁰ atoms/cm³, for example.

Moreover, when the thickness of the silicon oxide layer 22 exceeds 400 nm, plastic deformation cannot be sufficiently suppressed. On the contrary, when the thickness of the silicon oxide layer 22 is less than 10 nm, bonding is not performed well, and a void is generated. When the thickness of the silicon oxide layer 22 is 10 to 400 nm, the nitride semiconductor substrate 1 can be made with even more suppressed plastic deformation.

Also, when the resistivity of the single crystal silicon substrate 21 exceeds 50 mΩcm, plastic deformation cannot be sufficiently suppressed. The lower limit of the resistivity of the single crystal silicon substrate 21 is not particularly limited but can be 2 mΩcm, for example.

Moreover, by virtue of the resistivity of the single crystal silicon thin film 23 being 100 Qcm or more, the device for high frequency having excellent high frequency characteristics can be manufactured. The upper limit of the resistivity of the single crystal silicon thin film 23 is not particularly limited but can be 30000 Qcm, for example.

### [Method for Manufacturing Nitride Semiconductor Substrate]

An inventive method for manufacturing a nitride semiconductor substrate includes the steps of:
providing two single crystal silicon substrates serving as a bond wafer and a base wafer;
bonding the two single crystal silicon substrates to each other via a silicon oxide layer;
thinning the bond wafer into a single crystal silicon thin film to obtain an SOI substrate, in which the single crystal silicon thin film is formed via the silicon oxide layer on the base wafer; and
growing a nitride semiconductor layer including a GaN layer on the single crystal silicon thin film of the SOI substrate to obtain a nitride semiconductor substrate having the nitride semiconductor layer formed on the SOI layer.

In the step of providing two single crystal silicon substrates, as the single crystal silicon substrate serving as the bond wafer, the substrate containing nitrogen at a concentration of 2.0 × 10¹⁴ atoms/cm³ or more and having a resistivity of 100 Qcm or more is provided. The upper limit of the nitrogen concentration of the single crystal silicon substrate serving as the bond wafer is not particularly limited but can be 1.0 × 10²⁰ atoms/cm³, for example. Moreover, the upper limit of the resistivity of the single crystal silicon substrate serving as the bond wafer is not particularly limited but can be 30000 Qcm, for example.

The single crystal silicon substrate serving as the bond wafer is preferably the single crystal silicon substrate manufactured by an FZ method or an MCZ method and having a plane orientation of (111). The nitrogen concentration of 2.0 × 10¹⁴ atoms/cm³ or more can be achieved by, for example, doping nitrogen in the production process of the single crystal silicon according to the FZ method or the MCZ method.

Moreover, as the single crystal silicon substrate serving as the base wafer, the substrate having a resistivity of 50 mΩcm or less is provided. The lower limit of the resistivity of the single crystal silicon substrate serving as the base wafer is not particularly limited but can be 2 mΩcm, for example.

The single crystal silicon substrate serving as the base wafer is preferably the single crystal silicon substrate manufactured by the CZ method and having a plane orientation of (100).

Furthermore, the single crystal silicon substrate serving as the bond wafer is, for example, thermally oxidized to form the silicon oxide layer having a thickness of 10 to 400 nm on the surface. It is preferred that the silicon oxide layer having a thickness of 10 to 200 nm is formed.

Then, the single crystal silicon substrate serving as the bond wafer is laminated to and brought together with the single crystal silicon substrate serving as the base wafer via the silicon oxide layer having a thickness of 10 to 400 nm, and then performed bonding heat treatment at, for example, 1150°C for about 2 hours to bond them each other.

Then, the bond wafer is processed to make a thickness of, for example, about 100 to 200 nm to obtain the single crystal silicon thin film. This processing method is not particularly limited, but the method of delamination by hydrogen ion implantation followed by polishing is easier and thus preferred.

By this process, as shown in, for example, FIG. 1, an SOI substrate 2 in which a single crystal silicon thin film 23 is formed on a base wafer (single crystal silicon substrate) 21 via the silicon oxide layer 22 can be obtained.

By using the SOI substrate 2 thus provided as a starting substrate, the nitride semiconductor layer including the GaN layer is grown on the SOI substrate 2. For example, as shown in FIG. 2, first, an AlN layer 31 is formed with a thickness of, for example, 150 nm, and then an AlGaN layer 32 is formed with a thickness of, for example, 160 nm. Next, superlattice layers (SLs) 33 are formed by laminating alternately with 40 to 60 pairs of the GaN layers and the AlN layers. Then, a GaN layer 34 having a thickness of, for example, 800 to 1200 nm is formed. Then, a barrier layer made of the AlGaN layer 32 having a thickness of, for example, 3 nm is formed, and a cap layer made of the GaN layer 34 having a thickness of, for example, 3 nm is formed further on top of the barrier layer, thereby manufacturing a nitride semiconductor substrate 1 (GaN-HEMT epitaxial growth substrate) 1 in which a nitride semiconductor layer 3 is formed on the SOI substrate 2, as shown in FIG. 2.

According to such an inventive method for manufacturing the nitride semiconductor substrate, the inventive nitride semiconductor substrate can be manufactured. However, the method for manufacturing the inventive nitride semiconductor substrate is not limited to the manufacturing method described above.

Thus, in the inventive method for manufacturing the nitride semiconductor substrate, a nitride semiconductor thin film including the AlN layer 31, the GaN layer 34, and the AlGaN layer 32 is formed on the SOI substrate 2 in which the single crystal silicon thin film is formed on the single crystal silicon substrate serving as the base wafer via the silicon oxide layer. As the single crystal silicon substrate serving as the bond wafer, the substrate that contains nitrogen at a concentration of 2.0 × 10¹⁴ atoms/cm³ or more and has a resistivity of 100 Qcm or more is used, and as the single crystal silicon substrate serving as the base wafer, the substrate that has a resistivity of 50 mΩcm or less is used, and as the silicon oxide layer, the layer that has a thickness of 10 to 400 nm, preferably 10 to 200 nm is used. Consequently, the nitride semiconductor substrate can be manufactured with relatively improved strength even with high resistivity, and the nitride semiconductor substrate is particularly applicable to devices for the high frequency with excellent high frequency characteristics and has suppressed plastic deformation.

### EXAMPLES

Hereinafter, the present invention will be specifically described with reference to Examples and Comparative Examples. However, the present invention is not limited thereto.

### (Example 1)

As shown in FIG. 2, a nitride semiconductor layer 3 having a thickness of 1.8 um was epitaxially grown on an SOI substrate 2 to obtain a nitride semiconductor substrate (GaN-HEMT substrate) 1 of Example 1.

In this case, an SOI substrate having a diameter of 150 mm and meeting the following condition was used as the SOI substrate 2.

As a single crystal silicon substrate (Bond Substrate) serving as a bond wafer, the single crystal silicon substrate manufactured by an MCZ method with nitrogen-doping, having a plane orientation of (111), containing nitrogen at a concentration of 5 × 10¹⁴ atoms/cm³, and having a resistivity of 1200 Qcm was provided.

As a single crystal silicon substrate (Base Substrate) serving as a base wafer, the single crystal silicon substrate manufactured by a CZ method, having a plane orientation of (100), a resistivity of 8 mΩcm, and a thickness of 675 um was provided.

The provided bond wafer was thermally oxidized to form a silicon oxide layer having a thickness of 200 nm on a surface of the bond wafer.

Then, the bond wafer was implanted with hydrogen ions through an oxide film to form a bubble layer, then was laminated and brought together with the single crystal silicon substrate serving as the base wafer via the silicon oxide layer. Subsequently, heat-treatment was performed to delaminate the bond wafer at the bubble layer, then bonding heat treatment was performed at 1150°C for 2 hours to bond the substrate to each other.

Consequently, a single crystal silicon thin film (SOI layer) that contained nitrogen at a concentration of 5×10¹⁴ atoms/cm³, and had a resistivity of 1200 Qcm and a thickness of 100 nm was obtained.

With this processing, as shown in FIG. 1, the SOI substrate 2, in which a single crystal silicon thin film 23 was formed on the base wafer (single crystal silicon substrate) 21 via the silicon oxide layer (BOX Layer) 22, was obtained.

In Example 1, the nitride semiconductor layer 3 was formed by epitaxial growth, following a procedure described earlier with referring to FIG. 2, on the SOI substrate 2 obtained as described above.

### (Comparative Example 1)

A nitride semiconductor substrate of Comparative Example 1 was obtained with the same procedure as in Example 1 except that a substrate was used as a single crystal silicon substrate serving as a bond wafer, the substrate having been manufactured by an FZ method without doping nitrogen and having a plane orientation of (111) and a resistivity of 5535 Qcm .

### (Comparative Example 2)

A nitride semiconductor substrate of Comparative Example 2 was obtained with the same procedure as in Comparative Example 1, except that a provided bond wafer was thermally oxidized to form a silicon oxide layer having a thickness of 400 nm on a surface of a bond wafer.

### (Example 2)

A nitride semiconductor substrate of Example 2 was obtained with the same procedure as in Example 1, except that a provided bond wafer was thermally oxidized to form a silicon oxide layer having a thickness of 400 nm on a surface of a bond wafer.

### (Comparative Example 3)

A nitride semiconductor substrate of Comparative Example 3 was obtained with the same procedure as in Comparative Example 1, except that a provided bond wafer was thermally oxidized to form a silicon oxide layer having a thickness of 650 nm on a surface of a bond wafer.

### (Comparative Example 4)

A nitride semiconductor substrate of Comparative Example 4 was obtained with the same procedure as in Example 1, except that a provided bond wafer was thermally oxidized to form a silicon oxide layer having a thickness of 650 nm formed on a surface of a bond wafer.

### (Comparative Example 5)

A nitride semiconductor substrate of Comparative Example 5 was obtained with the same procedure as in Comparative Example 4, except that, as a single crystal silicon substrate serving as a base wafer, the single crystal silicon substrate was used, in which the substrate was manufactured by a CZ method, and had a plane orientation of (100), a resistivity of 8 mΩcm, a thickness of 675 um, and a back-surface CVD oxide film having a thickness of 600 nm formed on the opposite surface to the surface where a bond wafer was bonded.

### (Comparative Example 6)

A nitride semiconductor substrate of Comparative Example 6 was obtained with the same procedure as in Comparative Example 4, except that a single crystal silicon thin film had a thickness of 200 nm.

Table 1 below shows details of SOI substrates, and warps after epitaxial growth of nitride semiconductor layers, for Examples 1 and 2 and Comparative Examples 1 to 6.

**[Table 1]**

| | Single Crystal Silicon Thin Film (SOI Layer) | | | | Silicon Oxide Layer (BOX Layer) | Single Crystal Silicon Substrate | | Warp (µm) |
|---|---|---|---|---|---|---|---|---|
| | Production Method | Thickness (nm) | Resistivity (Ωcm) | Nitrogen Concentration (atoms/cm³) | Thickness (nm) | Resistivity (mΩcm) | Thickness (µm) | |
| Comparative Example 1 | FZ | 100 | 5535 | - | 200 | 8 | 675 | 55 |
| Example 1 | MCZ | 100 | 1200 | 5×10¹⁴ | 200 | 8 | 675 | 16 |
| Comparative Example 2 | FZ | 100 | 5535 | - | 400 | 8 | 675 | 60 |
| Example 2 | MCZ | 100 | 1200 | 5×10¹⁴ | 400 | 8 | 675 | 25 |
| Comparative Example 3 | FZ | 100 | 5535 | - | 650 | 8 | 675 | 284 |
| Comparative Example 4 | MCZ | 100 | 1200 | 5×10¹⁴ | 650 | 8 | 675 | 180 |
| Comparative Example 5 | MCZ | 100 | 1200 | 5×10¹⁴ | 650 | 8 | 675 | 287 |
| Comparative Example 6 | MCZ | 200 | 1200 | 5×10¹⁴ | 650 | 8 | 675 | 199 |

As clear from the results shown in Table 1, it is indicated that warps after epitaxial growth of the nitride semiconductor substrates of Examples 1 and 2 are ±50 um or less, which is a general standard of a device for production, and the plastic deformation is sufficiently suppressed.

On the other hand, it is indicated that the nitride semiconductor substrates of Comparative Examples 1 and 2, which did not use the substrates containing nitrogen at a concentration of 5 × 10¹⁴ atoms/cm³ as the single crystal silicon substrate serving as the bond wafer, had the warps after epitaxial growth exceeding ±50 um, and thus the plastic deformation was not sufficiently suppressed.

Furthermore, it is indicated that the nitride semiconductor substrates of Comparative Examples 3 to 6, which used the layers having thicknesses of larger than 400 nm as the silicon oxide layers, had the warps after epitaxial growth exceeding ±50 um, and thus the plastic deformation was not sufficiently suppressed.

### (Example 3)

A nitride semiconductor substrate of Example 3 was obtained with the same procedure as in Example 1, except that the single crystal silicon substrate being manufactured by a CZ method, and having a plane orientation of (100), a resistivity of 8 mΩcm, and a thickness of 1000 um was used as a single crystal silicon substrate serving as a base wafer.

### (Example 4)

A nitride semiconductor substrate of Example 4 was obtained with the same procedure as in Example 1, except that the single crystal silicon substrate being manufactured by an FZ method with nitrogen-doping, having a plane orientation of (111), containing nitrogen at a concentration of 5 × 10¹⁴ atoms/cm³, and having a resistivity of 3552 Qcm was used as a single crystal silicon substrate serving as a bond wafer,. That is, in Example 4, as in Example 1, a silicon oxide layer having a thickness of 200 nm was used.

### (Example 5)

A nitride semiconductor substrate of Example 5 was obtained with the same procedure as in Example 4, except that a provided bond wafer was thermally oxidized to form a silicon oxide layer having a thickness of 400 nm on a surface of a bond wafer.

### (Comparative Example 7)

A nitride semiconductor substrate of Comparative Example 7 was obtained with the same procedure as in Example 4, except that a provided bond wafer was thermally oxidized to form a silicon oxide layer having a thickness of 650 nm on a surface of a bond wafer.

Table 2 below shows the details of the SOI substrates, and the warps after epitaxial growth of the nitride semiconductor layers for Examples 3 to 5 and Comparative Example 7.

**[Table 2]**

| | Single Crystal Silicon Thin Film (SOI Layer) | | | | Silicon Oxide Layer (BOX Layer) | Single Crystal Silicon Substrate | | Warp (µm) |
|---|---|---|---|---|---|---|---|---|
| | Production Method | Thickness (nm) | Resistivity (Ωcm) | Nitrogen Concentration (atoms/cm³) | Thickness (nm) | Resistivity (mΩcm) | Thickness (µm) | |
| Example 3 | MCZ | 100 | 1200 | 5×10¹⁴ | 200 | 8 | 1000 | 8 |
| Example 4 | FZ | 100 | 3552 | 5×10¹⁴ | 200 | 8 | 675 | 18 |
| Example 5 | FZ | 100 | 3552 | 5×10¹⁴ | 400 | 8 | 675 | 40 |
| Comparative Example 7 | FZ | 100 | 3552 | 5×10¹⁴ | 650 | 8 | 675 | 270 |

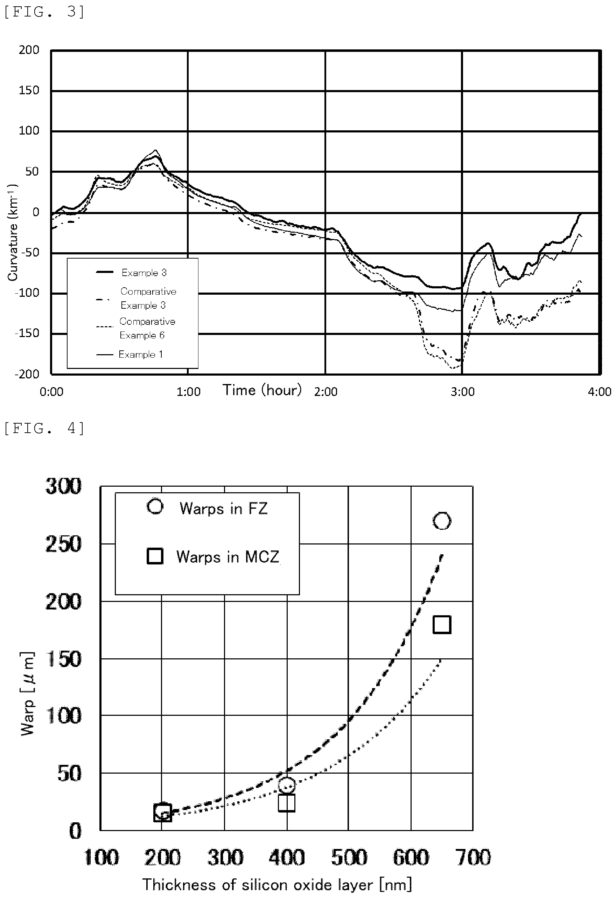

FIG. 3 shows a part of log data obtained from warp states during epitaxial growth as curvature in Examples 1 and 3, as well as in Comparative Examples 3 and 6.

As shown in FIG. 3, Comparative Example 3 and Comparative Example 6 in which the silicon oxide layers have a thickness of 650 nm, show large plastic deformation at about 2 hours and 40 minutes.

On the other hand, it is indicated in FIG. 3 that the warps of the substrates during epitaxial growth in Examples 1 and 3 were suppressed compared to those in Comparative Examples 3 and 6.

In addition, FIG. 4 shows a relation between the thicknesses and the warps of the silicon oxide layers in Examples and Comparative Examples.

Specifically, square plots and dotted approximate curves show the change in the warps when the silicon oxide layer (BOX) thicknesses were varied to 200 nm (Example 1), 400 nm (Example 2), and 650 nm (Comparative Example 4), using the bond wafers manufactured by the MCZ method and provided.

In addition, circular plots and dotted approximate curves show the change in the warps when the silicon oxide layer (BOX) thicknesses were varied to 200 nm (Example 4), 400 nm (Example 5), and 650 nm (Comparative Example 7), using the bond wafers manufactured by the FZ method and provided.

As can be understood from FIG. 4, regardless of whether the bond wafers were manufactured by the MCZ method or the FZ method, the warps were 50 um or less in Examples where the silicon oxide layer (BOX layers) thicknesses were 400 nm or less, in which the warps were significantly suppressed compared with Comparative Examples with the silicon oxide layers having a thickness of 650 nm.

It should be noted that the present invention is not limited to the above-described embodiments. The embodiments are just examples, and any examples that have substantially the same features and demonstrate the same functions and effects as those in the technical concept disclosed in claims of the present invention are included in the technical scope of the present invention.

## Claims

1. A nitride semiconductor substrate for high frequency comprising:
an SOI substrate in which a single crystal silicon thin film is formed on a single crystal silicon substrate via a silicon oxide layer; and
a nitride semiconductor layer including a GaN layer formed on the SOI substrate,
wherein the single crystal silicon thin film contains nitrogen at a concentration of 2.0 × 10¹⁴ atoms/cm³ or more and has a resistivity of 100 Qcm or more,
the single crystal silicon substrate has a resistivity of 50 mΩcm or less, and
the silicon oxide layer has a thickness of 10 to 400 nm.

2. The nitride semiconductor substrate according to claim 1,
wherein the silicon oxide layer has a thickness of 10 to 200 nm.

3. A method for manufacturing a nitride semiconductor substrate for high frequency, the method comprising the steps of:
providing two single crystal silicon substrates serving as a bond wafer and a base wafer;
bonding the two single crystal silicon substrates to each other via a silicon oxide layer;
thinning the bond wafer into a single crystal silicon thin film to obtain an SOI substrate, in which the single crystal silicon thin film is formed via the silicon oxide layer on the base wafer; and
growing a nitride semiconductor layer including a GaN layer on the single crystal silicon thin film of the SOI substrate to obtain a nitride semiconductor substrate having the nitride semiconductor layer formed on the SOI layer,
wherein a substrate containing nitrogen at a concentration of 2.0 × 10¹⁴ atoms/cm³ or more and having a resistivity of 100 Qcm or more is used as the single crystal silicon substrate serving as the bond wafer,
a substrate having a resistivity of 50 mΩcm or less is used as the single crystal silicon substrate serving as the base wafer, and
a layer having a thickness of 10 to 400 nm is used as the silicon oxide layer.

4. The method for manufacturing a nitride semiconductor substrate according to claim 3,
wherein a layer having a thickness of 10 to 200 nm is used as the silicon oxide layer.

5. The method for manufacturing a nitride semiconductor substrate according to claim 3 or 4,
wherein the single crystal silicon substrate serving as the bond wafer is manufactured by an FZ method or an MCZ method and provided.
